(19) Europäisches Patentamt
European Patent Office
Office européen des brevets

(11) **EP 1 240 675 B1**

(12) **EUROPÄISCHE PATENTSCHRIFT**

(45) Veröffentlichungstag und Bekanntmachung des Hinweises auf die Patenterteilung:
**15.09.2010 Patentblatt 2010/37**

(21) Anmeldenummer: **00993455.5**

(22) Anmeldetag: **15.12.2000**

(51) Int Cl.:
***H01L 41/083*** (2006.01)

(86) Internationale Anmeldenummer:
**PCT/DE2000/004484**

(87) Internationale Veröffentlichungsnummer:
**WO 2001/045138 (21.06.2001 Gazette 2001/25)**

(54) **ZWISCHENPRODUKT FÜR EIN PIEZOELEKTRISCHES BAUELEMENT**

INTERMEDIATE PRODUCT FOR PIEZOELECTRIC COMPONENT

PRODUIT INTERMEDIAIRE POUR COMPOSANT PIEZOELECTRIQUE

(84) Benannte Vertragsstaaten:
**AT BE CH CY DE DK ES FI FR GB GR IE IT LI LU MC NL PT SE TR**

(30) Priorität: **16.12.1999 DE 19960849**

(43) Veröffentlichungstag der Anmeldung:
**18.09.2002 Patentblatt 2002/38**

(73) Patentinhaber: **EPCOS AG**
**81669 München (DE)**

(72) Erfinder:
- **FELTZ, Adalbert**
  **A-8530 Deutschlandsberg (AT)**
- **GANSBERGER, Sigrid**
  **A-8010 Graz (AT)**
- **FLORIAN, Heinz**
  **A-8524 Bad Gams (AT)**
- **KASTL, Harald**
  **A-8524 Bad Gams (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
WO-A-01/24287      DE-A- 19 916 380
US-A- 4 353 958     US-A- 4 755 493
US-A- 5 433 917     US-A- 5 648 012

- **PATENT ABSTRACTS OF JAPAN vol. 017, no. 165 (E-1343), 30. März 1993 (1993-03-30) & JP 04 324687 A (ONODA CEMENT CO LTD), 13. November 1992 (1992-11-13) -& JP 04 324687 A (ONODA CEMENT CO LTD) 13. November 1992 (1992-11-13)**
- **HIRAKATA K ET AL: "Multilayer capacitors with copper inner electrodes" FERROELECTRICS, Bd. 133, Nr. 1-4, 1992, Seiten 139-144, XP001010835 ISSN: 0015-0193**
- **PATENT ABSTRACTS OF JAPAN vol. 016, no. 478 (E-1274), 5. Oktober 1992 (1992-10-05) & JP 04 171990 A (TOTO LTD; NAGATA KUNIHIRO), 19. Juni 1992 (1992-06-19) -& JP 04 171990 A (TOTO LTD; NAGATA KUNIHIRO) 19. Juni 1992 (1992-06-19)**
- **NAGATA K: "Properties of piezoelectric ceramics sintered in reducing atmosphere" JAPANESE JOURNAL OF APPLIED PHYSICS, PART 1 (REGULAR PAPERS & SHORT NOTES), Bd. 30, Nr. 9B, September 1991 (1991-09), Seiten 2224-2227, XP000269860 ISSN: 0021-4922**

**Beschreibung**

Die Erfindung betrifft ein Zwischenprodukt für die Herstellung eines piezoelektrischen Bauelements nach Patentanspruch 1, mit einem Stapel aus mindestens zwei Keramikschichten und einer zwischen zwei Keramikschichten angeordneten kupferhaltigen Elektrodenschicht und einem thermohydrolytisch abbaubaren Binder Polyurethan.

Derartige piezokeramische Bauelemente umfassen demnach mehrere, insbesondere viele Schichten (Vielschichtbauelemente); sie sind zum Beispiel als Aktoren in Piezostapeln (Piezostacks) nutzbar, indem durch Spannungsansteuerung eine trägheitsarme mechanische Auslenkung vergleichsweise hoher Kraft erreicht wird oder als Biegeelemente einsetzbar, indem die Spannungsansteuerung eine hohe mechanische Auslenkung geringerer Kraft hervorruft, oder sie gestatten die Erzeugung hoher elektrischer Spannungen beziehungsweise dienen in entsprechenden Vorrichtungen der Detektion mechanischer oder der Erzeugung akustischer Schwingungen.

Bisherige technische Lösungen basieren vorwiegend auf Keramikmassen vom Strukturtyp der Perowskite der allgemeinen Formel $ABO_3$, wobei die piezoelektrischen Eigenschaften im ferroelektrischen Zustand zum Tragen kommen. Als besonders vorteilhaft haben sich durch bestimmte Zusätze modifizierte Bleizirkonattitanat - Keramiken, $Pb(Zr_{1-x}Ti_x)O_3$ = PZT, erwiesen, deren Zusammensetzung auf die sogenannte morphotrope Phasengrenze zweier koexistierender ferroelektrischer Phasen, einer tetragonalen und einer rhomboedrischen Phase, eingestellt ist. Zwischen den nach typischen Verfahren der Keramik - Folientechnologie hergestellten Keramikschichten befinden sich mittels Siebdruck aufgebrachte Edelmetall - Innenelektroden, zum Beispiel Ag/Pd im Molverhältnis 70/30. Bei bis zu mehreren hundert Elektrodenschichten sind die Bauelemente dadurch mit erheblichen Kosten belastet. Die Edelmetallelektroden gestatten, die im Prozeß der Keramikfolien-herstellung angewandten Dispergatoren und Binder sowie die weiteren organischen Additive und ebenso die organischen Bestandteile der Siebdruck - Metallpaste aus den Vielschichtstapeln an der Luft durch Depolymerisation und Oxidation thermisch zu eliminieren, so daß anschließend eine Sinterverdichtung bei ca. 1100 bis 1150°C ermöglicht wird, ohne daß Reduktionseffekte, etwa bedingt durch verbliebene Kohlenstoffreste, wirksam werden, die die Eigenschaften der Keramik infolge von Reduktionsreaktionen negativ beeinflussen.

In der Literatur sind vor allem Untersuchungen an mit $La_2O_3$ oder $Nd_2O_3$ dotierter $Pb(Zr,Ti)O_3$ - Keramik dokumentiert, z. B. von G. H. Haertling in den Zeitschriften American Ceramic Society Bulletin 43(12), 113 - 118 (1964) und Journal of the American Ceramic Society 54, 1 -11 (1971) sowie in den Monographien "Piezoelectric Ceramics", Academic Press, London und New York (1971) von B. Jaffe, W. R. Cook und H. Jaffe sowie von Y. Xu. in "Ferroelectric Materials and their Applications", Elsevier Science Publishers, Amsterdam (1991).

$La_2O_3$ - bzw. $Nd_2O_3$ - Zusätze induzieren die Bildung von Kationenleerstellen auf den Pb - Plätzen der Kristallstruktur, erhöhen dabei aber vor allem bei nicht hinreichendem Sauerstoffpartialdruck zugleich die Tendenz, als Donatoren zu wirken, was zur Erniedrigung des Isolationswiderstandes und einem Anstieg der dielekrischen Verluste führen kann, d. h. die Empfindlichkeit der Keramik gegenüber Reduktion wird erhöht. Zugleich stabilisieren sie die tetragonale Phase, und die Kinetik der Ausrichtung der Domänen in Feldrichtung bei der Polung wird gefördert, d. h. das für den Anwendungszweck angestrebte elektromechanische Eigenschaftsverhalten einer sogenannten "weichen Piezokeramik" wird durch derartige Zusätze günstig beeinflußt. Zur Förderung der Sinterverdichtung und um Verdampfungsverluste an PbO aus der Keramik zu unterbinden, wird im allgemeinen ein geringer PbO - Überschuß bei der Einwaagezusammensetzung berücksichtigt. Über den Zusammenhang zwischen Grad der Dotierung durch $La_2O_3$ in einer mit 3 mol-% PbO - Überschuß versehenen $Pb(Zr_{0,47}Ti_{0,53})O_3$ - Keramik und dem Sinterverhalten sowie der damit verbundenen Gefügeausbildung und den elektromechanischen Eigenschaften wie Kopplungsfaktor und Dielektrizitätskonstante einschließlich der Curie - Temperatur, der oberen Grenztemperatur für ferroelektrisches und damit auch piezoelektrisches Verhalten, ist von M. Hammer und M. Hoffmann im Journal of Electroceramics 2(2), 75 - 84 (1998) eingehend berichtet worden.

Es sind auch Keramikmassen mit Wismutoxid anstelle von Bleioxid in Betracht gezogen worden, z. B. $(Bi_{0,5}Na_{0,5})TiO_3$ - $KNbO_3$ - $BiScO_3$ von T. Takenaka, H. Nagata in Proceedings of the 11th Internat. Symp. Appl. of Ferroelectrics , Montreux 1998, IEEE 98CH36245, 559 - 562 (1998), oder es wurde $Pb(Ti_xZr_{1-x})O_3$ mit $BiScO_3$ und/oder $BiInO_3$ kombiniert. All diesen Keramiken liegen Perowskit - Mischkristallphasen zugrunde, die in Kombination mit Ag/Pd - Innenelektroden ein für den Anwendungs-zweck als Piezostack relativ günstiges Eigenschaftsverhalten ergeben, wenn die Entbinderung, d.h. die Entfernung des oder der Binder, und die Sinterverdichtung in Gegenwart von Luft vorgenommen wird.

In der Druckschrift US 5 648 012 werden piezoelektrische Keramikmassen der allgemeinen Zusammensetzung $(Pb_{1-x-\alpha-y}Sr_xNa_\alpha M_y)_a[(Nb_bY_cCr_dCo_eSb_\beta)_fTigZr_{1-f-g}]O_3$ geschützt, die sich durch hohe elektromechanische Kopplungsfaktoren auszeichnen, wobei M mindestens ein Seltenerdmetall von La, Gd, Nd, Sm und Pr ist und die Parameterbereiche $0,005 \leq x \leq 0,08$, $0,002 \leq y \leq 0,05$, $0,95 \leq a \leq 1,05$, $0,47 \leq b \leq 0,70$, $0,02 \leq c \leq 0,31$, $0,11 \leq d \leq 0,42$, $0,01 \leq e \leq 0,12$, $0,02 \leq f \leq 0,15$, $0,46 \leq g \leq 0,52$, $0 \leq \alpha \leq 0,005$, $0 \leq \beta \leq 0,13$ sowie $b+c+d+e+\beta=1,00$ genannt sind.

Der Druckschrift DE 9700463 zur Herstellung von Grünfolien für piezokeramische Vielschichtbauelemente liegt gleichfalls ein Piezokeramikpulver vom Typ PZT zugunde, dem ein stöchiometrischer Überschuß eines heterovalenten Seltenerdmetalls bis zu einem Gehalt von 1 bis 5 mol-% und ein stöchiometrischer Überschuß von zusätzlich 1 - 5 mol-% Bleioxid zugegeben wird. In dieser Druckschrift wird außerdem dokumentiert, daß $Ag^+$ - Ionen aus dem Bereich der Ag/Pd - Innenelektroden gerade in einem solchen Anteil in die Keramikschichten der Vielschichtbauelemente eindiffundieren, daß die durch die heterovalente Dotierung entstandenen Kationenleerstellen besetzt werden und sich auf diese Weise eine aufgefüllte Perowskitstruktur ergibt, wie zum Beispiel $Pb_{0,99}Ag_{0,01}La_{0,01}[Zr_{0,30}Ti_{0,36}(Ni_{1/3}Nb_{2/3})_{0,34}]O_3$ oder $Pb_{0,96}Ag_{0,02}Nd_{0,02}(Zr_{0,54}Ti_{0,46})O_3$. Im letzteren Fall resultiert eine Piezokeramik mit vergleichsweise hoher Curie - Temperatur für Anwendungen bis zu 150°C. Es wird auch begründet, daß durch den Silbereinbau in die Keramik die Verbundfestigkeit zwischen der Ag/Pd - Innenelektrode (70/30) und der Keramik sowie das Kornwachstum beim Sintern günstig beeinflußt werden.

Um den Nachteil der Kostenbelastung bei derartigen piezokeramischen Vielschichtbauelementen auf der Basis einer Keramik vom PZT - Typ zu vermeiden, ist es möglich, eine Anwendung von Kupfer anstelle der teuren Ag/Pd - Innenelektroden vorzusehen. Thermodynamische Daten belegen, daß PZT - Keramik zum Beispiel bei 1000°C unter einem bestimmten sehr niedrigen Sauerstoffpartialdruck von $< 10^{-2}$ Pa nicht reduziert und metallisches Kupfer unter diesen Bedingungen zugleich stabil ist, d. h. nicht oxidiert wird.

Aus der Druckschrift US 5,233,260 sind Piezoaktoren mit Cu-Elektroden bekannt, die allerdings nicht in monolithischer Bauweise ausgeführt sind. Vielmehr werden die Keramikschichten getrennt gesintert und erst anschließend verstapelt und verklebt. Entsprechend aufwendig ist das Herstellungsverfahren. Diese Piezoaktoren haben ferner den Nachteil, daß der verwendete Kleber sich nachteilig auf die elektrischen Eigenschaften auswirken.

Daß diese Aussage auch auf eine Donator dotierte Keramik zutrifft, wird durch eine Untersuchung von Cao und Mitarbeiter im Journal of the American Ceramic Society 76(12) 3019 (1993) nachgewiesen, indem Cu - Folien zwischen vorgefertigte Keramik-scheiben $Pb_{0,988}(Nb_{0,024}Zr_{0,528}Ti_{0,473})O_3$ gelegt werden und eine derartige mehrfache Sandwichanordnung unter Vakuum einer Sinterung bei 1050 °C unterzogen wird. Es wird der gute Verbund zwischen Keramik und Cu - Innenelektrode und das Ausbleiben von Migrationseffekten, wie sie bei Ag - Elektroden an der Luft beobachtet werden, hervorgehoben. Eine solche Vorgangsweise entspricht jedoch nicht den Anforderungen einer rationellen Fertigung, wie sie die Folien - Vielschichttechnologie ermöglicht, und ist nicht für eine Massenfertigung geeignet.

Kato und Mitarbeiter beschreiben in Ceramic Transactions Vol. 8, Seite 54 - 68 (1990) die Herstellung von Vielschicht-Kondensatoren mit Z5U Spezifikation auf der Basis von Keramiken der allgemeinen Formel $(Pb_a\text{-}Ca_b)$ $(Mg_{1/3}Nb_{2/3})_xTi_y(Ni_{1/2}W_{1/2})_zO_{2+a+b}$ (a+b>1, x+y+z=1) mit Cu - Innenelektroden, indem sie eine Kupferoxid - Siebdruckpaste anwenden. Dadurch ist Entbinderung an der Luft möglich. Die Kohlenstoffbildung, die unter Stickstoff bei einem mit metallischem Kupfer verträglichen Sauerstoffpartialdruck unvermeidbar eintreten und bei der anschließenden Sinterverdichtung zu einer reduktiven Degradation der Keramik mit Cu/Pb - Legierungsbildung - der eutektische Schmelzpunkt liegt bei $T_S$ = 954 °C -, führen würde, wird damit umgangen. Nach der Entbinderung wird die Sinterverdichtung dann bei 1000°C unter Zudosieren von Wasserstoff bei einem Sauerstoffpartialdruck $< 10^{-3}$ Pa durchgeführt und das Kupferoxid unter diesen Bedingungen zu Kupfer reduziert. Der Prozeß ist auf Grund der Schwindung bei der Reduktion von Kupferoxid zu Kupfer und der daraus resultierenden Tendenz zur Delamination störanfällig und hat bisher keine technologische Umsetzung in Produkten erfahren.

In der Druckschrift DE 197 49 858 C1 wird bei der Herstellung von COG - Vielschicht-kondensatoren mit Cu - Innenelektroden auf der Basis einer Keramikmasse mit der allgemeinen Zusammensetzung $(Ba^{II}_{1-y}Pb_y)_{6-x}Nd_{8+2x/3}Ti_{18}O_{54}$ + z m-% $TiO_2$ + p m-% Glas

bei geringerem PbO - Gehalt (0,6 < x < 2,1; 0 < y < 0,6, 0 < z < 5,5 und 3 < p <10) eine hinreichende Eliminierung der organischen Bestandteile durch Einspeisung von Wasserdampf in den Stickstoffstrom mit $< 10^{-2}$ Pa Sauerstoffpartialdruck bei Temperaturen bis zu 680°C und die Sinterverdichtung bei 1000°C durch geeignete Glasfrittenzusätze erreicht. Das Verfahren konnte in der DE 19841487 auf COG - Vielschichtkondensatoren mit der PbO - freien Keramik $Ba^{II}_{6-x}(Sm_yNd_{1-y})_{8+2x/3}Ti_{18}O_{54}$ + p Gew.-% Glasfritte (1 < x < 2, 0,5.< y < 1,0 und 3 < p < 1) erfolgreich übertragen werden.

Die Erfindung bezieht sich auf ein Zwischenprodukt für die Herstellung eines piezoelektrischen Bauelements, wie in Anspruch 1 beansprucht. Es sind piezokeramische Bauelemente in monolithischer Vielschichtbauweise mit kupferhaltigen Innenelektroden auf der Basis einer Piezokeramik beliebiger Zusammensetzung, vorzugsweise auf der Basis einer Perowskitkeramik vom PZT - Typ vorgesehen. Dabei kommen die Modifizierung durch Mischkristallbildung sowohl durch den Einbau von Kationen auf den A - Plätzen als durch Substitution der B - Kationen durch geeignete andere Kationen oder Kombinationen von Kationen zustande, und die aus der Fertigung von Vielschicht-kondensatoren bekannten Verfahren der Keramikfolien - Technik sowie die Gemeinsamsinterung der Keramikschichten mit den zum Beispiel mittels Siebdruck alternierend eingebrachten Innenelektroden aus Kupfer oder einer Mischung von Cu mit Keramik bzw. weiteren Metallzusätzen können zur Anwendung gelangen.

Derartige piezokeramische Vielschichtbauelemente lassen sich zum Beispiel als Aktoren durch eine geeignete Prozeßführung realisieren, indem die Entbinderung der Grünfolienstapel durch Wasserdampf unter Vermeidung der Oxidation der Cu - haltigen Innenelektroden ausgeführt wird. Die anschließende Sinterverdichtung zu einem monolithischen Vielschichtbauelement kann in vorteilhafter Weise bereits bei 1000 °C, das heißt unterhalb der Schmelztemperatur des Kupfers, durchgeführt werden.

Vorteilhafte Weiterbildungen der Erfindung sind separat gekennzeichnet.

Der Vorteil der Erfindung besteht darin, daß anstelle der bisher üblicherweise verwendeten Ag/Pd - Innenelektroden (70/30) auf der Basis der Vielschicht-folientechnik für eine PZT - Keramikmasse kupferhaltige Innenelektroden zur Anwendung gelangen, indem die praktisch vollständige Entbinderung vor dem Einsetzen der Sinterverdichtung unter Inertbedingungen dadurch gelingt, daß man der Inertatmosphäre bei der Entbinderung reichlich Wasserdampf zuführt und nur einen bestimmten Sauerstoffpartialdruck zuläßt, der die Cu - haltigen Innenelektroden unversehrt läßt. Dadurch werden die Voraussetzungen geschaffen, daß im Prozeß der anschließenden Sinterverdichtung Piezoaktoren mit optimalen Eigenschaftswerten der Keramik erhalten werden, die denen einer unter analogen Bedingungen getrennt von der Cu - haltigen Elektrodenschicht oder auch an Luft gesinterten Piezokeramikschicht der betreffenden Zusammensetzung nicht nachstehen bzw. diese sogar noch übertreffen.

Es ist ein Bauelement vorteilhaft, bei dem auf A-Plätzen der Keramik Kationen eingebaut sind und bei dem Kationen auf B-Plätzen durch geeignete andere Kationen oder Kombinationen von Kationen ersetzt sind. Beispielsweise können auf A-Plätzen der Keramik zweiwertige Metallkationen $M^{II}$ eingebaut sind. Diese können beispielsweise aus einer Gruppe von Elementen ausgewählt sein, die Barium, Strontium, Kalzium, Kupfer und Wismut enthält. Für die A-Plätze der Keramik kommen zweiwertige Metallkationen $M^{II}$ aus einer Gruppe von Elementen in Betracht, die Scandium, Yttrium und Lanthan enthält oder auch aus der Gruppe der Lanthaniden.

Ferner können auf A-Plätzen der Keramik einwertige Kationen eingebaut sein, welche vorteilhaft ausgewählt sind aus einer Gruppe von Elementen, die Silber, Kupfer, Natrium und Kalium enthält.

Darüber hinaus ist es auch möglich, auf A-Plätzen Kombinationen von zweiwertigen Metallkationen $M^{II}$ und einwertigen Kationen einzubauen.

Ferner ist ein Bauelement vorteilhaft, bei dem zur partiellen Substituion der vierwertigen Kationen Zr und Ti auf den B - Plätzen der ferroelektrischen Perowskit - Keramik Kombinationen ein- und fünfwertiger Metallkationen $M^I_{1/4}M^V_{3/4}$ mit $M^I$ = Na, K und $M^V$ = Nb, Ta oder zwei- und fünfwertiger Metallkationen $M^{II}_{1/3}M^V_{2/3}$ mit $M^{II}$ = Mg, Zn, Ni, Co und $M^V$ = Nb, Ta oder drei- und fünfwertiger Metallkationen $M^{III}_{1/2}M^V_{2/3}$ mit $M^{III}$ = Fe, In, Sc, schwerere Lanthaniden - Elemente und $M^V$ = Nb, Ta oder Kombinationen $M^{III}_{2/3}M^{VI}_{1/3}$ mit $M^{III}$ = Fe, In, Sc, schwerere Lanthaniden - Elemente und $M^{VI}$ = W bzw. $M^{II}_{1/2}M^{Vi}_{1/2}$ mit $M^{II}$ = Mg, Co, Ni und $M^{VI}$ = W eingesetzt sind.

Ferner ist es vorteilhaft, wenn die Zusammensetzung der Keramik der allgemeinen Formel $Pb_{1-x-y}SE_xCu_yV'''_{x/2}(zr_{0,54-z}Ti_{0,46+z})O_3$ entspricht mit 0,01 < x < 0,05 und -0,15 < z < +0,15 sowie 0 < y < 0,06, wobei SE ein Seltenerdmetall und V eine Vakanz ist, und wobei ein PbO - Überschuß von 1 bis maximal 5 mol-% eingestellt ist.

Darüber hinaus kann die Keramik einen Zusatz an CuO enthalten.

Die Erfindung schließt die Erkenntnis ein, daß die durch Donatoren, z. B. ein Seltenerdmetall, dotierte Piezokeramik auf der Basis von PZT infolge Bildung von Kationenleerstellen auf den A - Plätzen der Perowskitstruktur, z. B. gemäß der Zusammensetzung $Pb^{II}_{0,97}Nd^{III}_{0,02}V''_{Pb,0,01}(Zr_{0,54}Ti_{0,46})O_3$ (V'' bedeutet hier eine Leerstelle), eine bestimmte Affinität entwickelt, Kupfer aus den Innenelektroden, ohne diese zu zerstören, unter Eliminierung äquivalenter PbO - Anteile aufzunehmen, wobei letztere Verbindung als Sinterhilfsmittel wirkt und der Keramik ohnehin separat bis zu einigen Prozent PbO zugesetzt ist.

Durch die bekannte Mobilität der Kupfer - Ionen wird die Sinterverdichtung gefördert, und es kommt durch die Kupfermigration zu einer festen Haftung zwischen Elektrodenschicht und Keramik, so daß Delaminationen auf diesem Wege wirksam unterbunden werden.

Es ist von Vorteil, bereits der Ausgangsmischung der eingesetzten Rezeptur für Piezostacks zum Beispiel auf der Basis von PZT mit Cu - Innenelektroden entsprechend der allgemeinen Formel $Pb^{II}_{1-x-y}SE^{III}xCu_yV'''_{x/2}(Zr_{0,54-z}Ti_{0,46+z})O_3$ mit 0,005 < x < 0,05 und -0,15 < z < +0,15 (SE = Seltenerdmetall) etwas CuO in den Grenzen 0 < y < 0,15 zuzusetzen. Die piezoelektrischen Eigenschaftsmerkmale, wie der hohe Wert für den elektromechanischen Kopplungsfaktor können bei entsprechender Anpassung des Parameters z an die morphotrope Phasengrenze erhalten bleiben.

Die Erfindung wird an folgenden Ausführungsbeispielen und den dazugehörigen fünf Figuren näher erläutert.

Die aus $TiO_2$, $ZrO_2$ bzw. einem durch Mischfällung hergestellten Precursor $(Zr,Ti)O_2$ und $PbCO_3$ bzw. $Pb_3O_4$ und Dotanden wie $La_2O_3$ oder einem anderen Oxid der Seltenerdmetalle und gegebenenfalls einem Zusatz von CuO bestehende Rohstoffmischung wird in ihrer Zusammensetzung auf die morphotrope Phasengrenze, einen PbO - Überschuß von maximal 5 % zur Förderung der Sinterverdichtung eingestellt, zur Gleichverteilung der Komponenten in wäßriger Suspension einer Mahlstufe unterzogen und nach dem Filtrieren und Trocknen bei 900 bis 950 °C kalziniert. Dabei bildet sich die piezokeramische Perowskit - Mischkristallphase. Um bereits bei 1000°C unterhalb der Schmelztemperatur von Kupfer in 2 bis 4 Stunden Sinterverdichtung zu erreichen, ist eine Feinmahlung bis auf eine mittlere Korngröße < 0,4 μm erforderlich. Die Sinteraktivität des Pulvers erweist sich dann als ausreichend, um eine Verdichtung von > 96% der theoretischen Dichte bei zugleich hinreichendem Kornwachstum und ausreichender mechanischer Festigkeit im Keramikgefüge zu gewährleisten.

Das fein gemahlene Pulver wird unter Verwendung eines Dispergators zu einem wäßrigen Schlicker mit ca. 70 m-% Feststoffgehalt, das entspricht etwa 24 Vol.-%, suspendiert. Dabei wird der für eine optimale Dispergierung gerade notwendige Dispergatoranteil in einer Versuchsreihe gesondert ermittelt, was am Erreichen eines Viskositätsminimums erkannt werden kann. Man fügt für die Ausbildung der Piezokeramik - Grünfolien zu den dispergierten Feststoffpulversuspensionen ca. 6 m-% eines handelsüblichen Binders, der thermohydrolytisch abbaubar ist, hinzu. Dafür erweist sich eine wässrige Polyurethandispersion als vorteilhaft. Man mischt in einer Dispermat - Mühle und erhält auf diesem Weg einen für den Folienziehprozeß bzw. für die Herstellung eines Sprühgranulats geeigneten Schlicker.

Scheibenförmige Preßlinge, hergestellt aus dem Granulat, oder quadratische Mehrlagenplättchen "MLP", durch Übereinanderstapeln und Laminieren aus den 40 bis 50 μm dicken Grünfolien ohne Bedruckung mit Cu - Elektrodenpaste gewonnen, lassen sich in einer $H_2O$ - Dampf enthaltenden Inertatmosphäre bei einem definierten Sauerstoffpartialdruck, der die Bedingung der Koexistenz von PbO bzw. $Bi_2O_3$ - enthaltender Piezokeramik und Kupfer erfüllt, bis auf einen Restkohlenstoffgehalt von 300 ppm entbindern.

Die hydrolytische Spaltung des Binders erfolgt zum Hauptteil bei sehr niedriger Temperatur von 220 ± 50 °C bei einem Wasserdampfpartialdruck größer 200 mbar. Der Sauerstoffpartialdruck wird auf einen Wert eingestellt, der mit den Cu - hältigen Elektroden verträglich ist. Dies erfolgt durch das Gettern des Sauerstoffs aus dem Gasstrom an großen Oberflächen von Cu oder durch Zudosierung von $H_2$. Er sinkt während der Entbinderung durch Oxidation an der Probe ab, der Gasstrom verhindert aber eine Schädigung der Keramik. Zwar tragen die Elektrodenschichten zu einer Entbinderung insofern bei, als durch sie bevorzugte Wege für einen Bindemittelabtransport entstehen, allerdings ist dennoch insbesondere für Aktoren mit 160 Elektroden (Abmaße 9,8 * 9,8 * 12,7 mm³) eine beträchtliche Entbinderungszeit nötig.

Die Erfindung ermöglicht somit die Herstellung von Aktoren mit mehr als 100 Innenelektroden, was den Vorteil einer hohen erzielbaren Aktor-Auslenkung hat.

Beispiele für eine Entbinderungsführung sind unter Angabe des verbleibenden Restkohlenstoffgehalts der erhaltenen Bauteile in Tab. 1 zu finden. Der Taupunkt für Wasserdampf der beiden Entbinderungsprogramme liegt bei 75 °C, der Partialdruck des Wasserdampfes entspricht 405 mbar.

**Tab. 1:** Entbinderung von Keramikproben MLP und Aktoren

| Profil | Bedingungen (R: Rampe, H: Haltezeit) | Proben | C |
|---|---|---|---|
| EK 1 | R: 30 K/h H: 220 °C/10 h R: 30 K/h H: 500 °C/20 h, bei 100 1/h $N_2$, 30 g/h $H_2O$, mit Cu-Getterung | Keramikproben MLP | 240 |
| EK 2 | R: 30 K/h H: 220 °C/40 h R: 30 K/h H: 500 °C/20 h, bei 100 1/h $N_2$, 30 g/h $H_2O$, mit Cu-Getterung | Aktor 160 Elektroden | 300 ±30 |

Für Aktoren mit 160 Schichten wird die Haltezeit bei 220 C auf 40 h verlängert (EK 2). Danach gelingt mit dem verbliebene Restkohlenstoff von 300 ± 30 ppm im angegebenen Sinterprofil eine Verdichtung der Keramik bei 1000°C ohne schädliche reduktive Degradation.

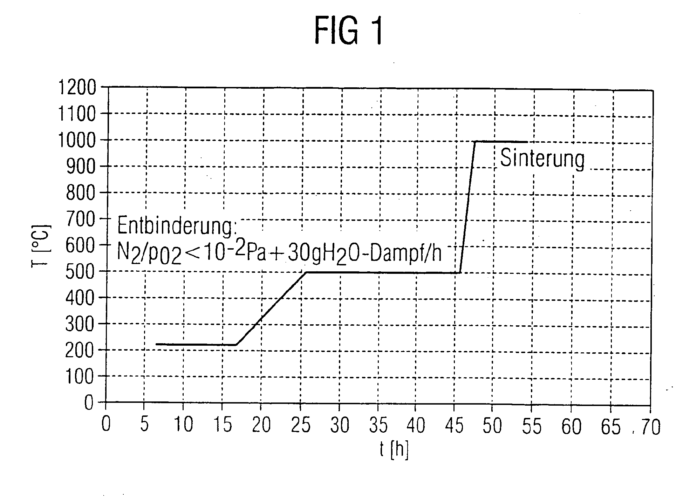

Figur 1 zeigt die Temperaturführung bei der Entbinderung und Sinterung. Der dem Stickstoffstrom entsprechend einem Taupunkt von 75°C zugeführte Wasserdampf-Partialdruck ist gleichfalls angegeben.

Bei derartig entbinderten PZT - Keramikproben gelingt die Sinterverdichtung bei 1000°C, ohne daß eine reduktive Degradation der Keramik zustande kommt. Nach dem Kontaktieren durch Sputtern von Au - Elektroden werden die dielektrischen und speziell die piezoelektrischen Eigenschaften an den erhaltenen Proben mit den Abmessungen von ca. 10.10 mm² und 0,7 bzw. 2 mm Dicke gemessen und mit den an der Luft entbinderten und bei 1130 °C gesinterten Proben gleicher Geometrie verglichen.

Für Sinterungen von Keramikproben MLP ohne Innenelektroden mit der Zusammensetzung $Pb^{II}_{0,97}Nd^{III}_{0,02}V'''_{0,01}(Zr_{0,54}Ti_{0,46})O_3$ an der Luft und unter Inertbedingungen, wobei letztere den Anforderungen für eine Gemeinsamsinterung mit Kupfer entsprechen, sind die Ergebnisse der elektrischen Messungen in Tabelle 2, die der gepolten Proben in Tabelle 3 bis 5 zusammengestellt. Zusätzlich sind die Kennwerte einer CuO-dotierten Keramikmasse bei Sinterung unter Inertbedingungen angeführt.

Tab.2: Eigenschaften von quadratischen Keramikproben MLP (Kantenlänge 1, Dicke h): Proben (a), (b) und (c) mit der Zusammensetzung $Pb_{0,97}Nd_{0,02}(Zr_{0,54}Ti_{0,46})O_3$, Probe (d) mit der Zusammensetzung $Pb_{0,96}Cu_{0,02}Nd_{0,02}$ $(Zr_{0,54}Ti_{0,46})O_3$ (a) Pulver vorgemahlen auf mittlere Korngröße $d_{50\%}$= 0,53 μm, Sinterung bei 1120°C an Luft; (b), (c) und (d) Pulver feingemahlen auf mittlere Korngröße $d_{50\%}$= 0,33 μm, gesintert (b) bei 1000°C an Luft bzw. (c) und (d) bei 1000°C unter $N_2/H_2O$-Dampf .

| Probe MLP | h/mm | l/mm | C/nF | ε | tan δ | $R_{IS}$/ Ω | ρ/ Ωcm |
|---|---|---|---|---|---|---|---|
| (a) | 0,59±0,02 | 10,8±0,1 | 2,20±0,05 | 30 | 1268± 2,1±0,1% | $1 * 10^{11}$ | $2 * 10^{12}$ |

(fortgesetzt)

| Probe MLP | h/mm | l/mm | C/nF | $\varepsilon$ | tan $\delta$ | $R_{IS}$/ $\Omega$ | $\rho$/ $\Omega$cm |
|---|---|---|---|---|---|---|---|
| (b) | 0,70±0,01 | 10,6±0,1 | 1,60±0,03 | 58 | 1137± 2,8±0,2% | 2 * 10^11 | 3 * 10^12 |
| (c) | 0,71±0,02 | 11,0±0,8 | 1,62±0,07 | 81 | 1132± 2,8±0,6% | 5 * 10^9 | 9 * 10^10 |
| (d) | 0,70±0,01 | 11,3±0,1 | 1,92±0,01 | 8 | 1196± 1,9±0,3% | 7 * 10^10 | 1 * 10^12 |

Tab. 3: Eigenschaften von quadratischen Keramikproben MLP (Kantenlänge 1, Dicke h) mit der Zusammensetzung gemäß Tabelle 2 nach der Polung mit 1200 V (a) bzw. 1400 V ((b) und (c) und (d)).

| Probe MLP | h/mm | 1/mm | C/nF | $\varepsilon$ | tan $\delta$□ | $R_{IS}$/ $\Omega$ | $\rho$/ $\Omega$cm |
|---|---|---|---|---|---|---|---|
| (a) | 0,59±0,02 | 10,8±0,1 | 2,54±0,13 | 1460± 134 | 1,9±0,1% | 1 * 10^11 | 2 * 10^12 |
| (b) | 0,70±0,01 | 10,6±0,1 | 1,70±0,03 | 1207± 58 | 2,1±0,1% | 1 * 10^11 | 2 * 10^12 |
| (c) | 0,71±0,02 | 11,0±0,8 | 1,75±0,050 | 1238± 69 | 2,3±0,1% | 2 * 10^11 | 5 * 10^12 |
| (d) | 0,70±0,01 | 11,3±0,1 | 2,11±0,01 | 1317± 69 | 10,2±0,8 % | 8 * 10^10 | 1 * 10^12 |

Die Eigenschaftswerte belegen, daß PZT - Keramikproben, die unter Ausschluß von Luft entbindert und gesintert wurden, vergleichbare dielektrische Eigenschaften aufweisen.

Den Ergebnissen der Tabelle 4 liegen elektromechanische Schwingungsmessungen mit Hilfe einer Impedanzmeßbrücke zugrunde, deren Auswertung aus der parallelen und seriellen Resonanzfrequenz $f_p$, $f_s$ des Schwingkreises gemäß

$$f_s = \frac{1}{2\pi} \cdot \sqrt{\frac{1}{C_1 \cdot L_1}} \qquad f_p = \frac{1}{2\pi} \cdot \sqrt{\frac{C_0 + C_1}{C_0 \cdot C_1 \cdot L_1}}$$

für jede Schwingungsmode der MLP Probe den effektiven Kopplungsfaktor nach

$$k_{eff}^2 = \frac{f_p^2 - f_s^2}{f_p^2} = \frac{\frac{C_0 + C_1}{C_0 \cdot C_1 \cdot L_1} - \frac{C_0}{C_0 \cdot C_1 \cdot L_1}}{\frac{C_0 + C_1}{C_0 \cdot C_1 \cdot L_1}} = \frac{C_1}{C_0 + C_1}$$

zu berechnen gestattet. Dabei gibt $C_1/(C_0+C_1)$ das Verhältnis der mechanischen Energie zur Gesamtenergie an.

Tab. 4: Effektive piezoelektrische Kopplungsfaktoren der MLP - Proben von Tabelle 3 für zwei Grundschwingungen, bestimmt aus der Messung von jeweils 3 MLP - Proben, gesintert unter den in Tabelle 2 angegebenen Bedingungen (a), (b) und (c).

| MLP | Planare Schwingung | | | Dickenschwingung | | |
|---|---|---|---|---|---|---|
| | $f_{S/kHz}$ | $f_{P/kHz}$ | $k_{eff}$ | $f_{S/kHz}$ | $f_{P/kHz}$ | $k_{eff}$ |
| (a) | 158±1 | 191±2 | 0,56±0,01 | 3292±15 | 3848±79 | 0,52±0,03 |
| (b) | 166±2 | 198±4 | 0,54±0,01 | 2900±78 | 3197±25 | 0,42±0,05 |
| (c) | 163±1 | 189±5 | 0,51±0,04 | 2830±111 | 3100±108 | 0,40±0,02 |

Die Messung der Curie - Temperatur an Proben (c) ergab einen Wert von 339 ± 2°C.

Tatsächlich ergeben sich für die unter den Bedingungen der Gemeinsamsinterung mit Kupfer gefertigten Proben elektromechanischen Kopplungsfaktoren, die im Bereich der an Luft gesinterten Proben liegen.

In Tabelle 5 sind die Ergebnisse einer Auslenkungsmessung an Keramikproben MLP aufgeführt. Die Auslenkung $\Delta$h wurde parallel zur Polungsrichtung 3 bestimmt, in der auch die Meßspannung angelegt war. Die Auslenkungsmessung erfolgte über induktive Wegmessung bei Anlegen eines elektrischen Feldes E mit einer Feldstärke von 2000 V/mm. Unmittelbar vor dieser Messung wurden die Proben mit einer Feldstärke von 2000 V/mm in Polungsrichtung beaufschlagt, um Nachpolarisationseffekte und vergrößerte Hysterese infolge der Lagerung nach der Polung auszuschließen.

Die relative Dehnung S der Keramikproben MLP berechnet sich aus der gemessenen Auslenkunung $\Delta$h geteilt durch die Probendicke h. Daraus ergibt sich der piezoelektrischen Koeffizienten $d_{33}$ nach der Definitionsgleichung.

$$S_3 = d_{33} * E_3$$

$d_{33}$ ist eine geometrieunabhängige Kenngröße für die piezoelektrischen Großsignaleigenschaften der untersuchten Keramik.

Tab. 5: Auslenkungsmessung an quadratischen Keramikproben MLP (Kantenlänge 1, Dicke h) mit der Zusammensetzung gemäß Tabelle 2 bei Anlegen einer Spannung von 2 kV / mm. Elektrische Meßspannung U, Auslenkung $\Delta$h und die piezoelektrische Konstante $d_{33}$ sind angeführt.

| Probe MLP | h/mm | U/V | $\Delta$h/$\mu$m | $d_{33}.10^{-12}$m/V |
|---|---|---|---|---|
| (a) | 0,59$\pm$0,02 | 1180$\pm$4 | 0,88$\pm$0,01 | 747$\pm$10 |
| (b) | 0,70$\pm$0,01 | 1400$\pm$4 | 0,99$\pm$0,01 | 712$\pm$10 |
| (c) | 0,71$\pm$0,02 | 1420$\pm$4 | 1,03$\pm$0,06 | 723$\pm$40 |
| (d) | 0,70$\pm$0,01 | 1400$\pm$4 | 1,03$\pm$0,01 | 739$\pm$4 |

Im Fall der Bedruckung mit Cu - Innenelektroden erweist sich eine Cu - Siebdruckpaste als vorteilhaft, die einen möglichst hohen Metallgehalt von ca. 75 m-% aufweist und mit einem besonders hochpolymeren und dadurch hochviskosen Binder aufbereitet wird, der bereits bei < 2 m-% bezogen auf den Feststoffgehalt eine möglichst thixotrope Viskosität von > 2000 mPa∗s ergibt. Zu Testzwecken werden zunächst Vielschichtproben "VS" mit bis zu 20 Innenelektroden hergestellt. Davon ausgehend werden in einem zweiten Schritt Piezostacks mit 100 bis 300 Cu - Innenelektroden aufgebaut und unter den genannten Bedingungen eines definierten Sauerstoffpartial-drucks in Gegenwart von Wasserdampf entbindert und gesintert.

Die Piezokeramik - Grünfolien werden in einer Dicke hergestellt, die unter Berücksichtigung eines linearen Schwunds bei der Sinterung von typischerweise 15% eine Piezokeramikdicke von 20 bis 200 $\mu$m ergibt. Die Cu - Elektroden haben nach der Sinterung eine Schichtdicke von 1 bis 3 $\mu$m.

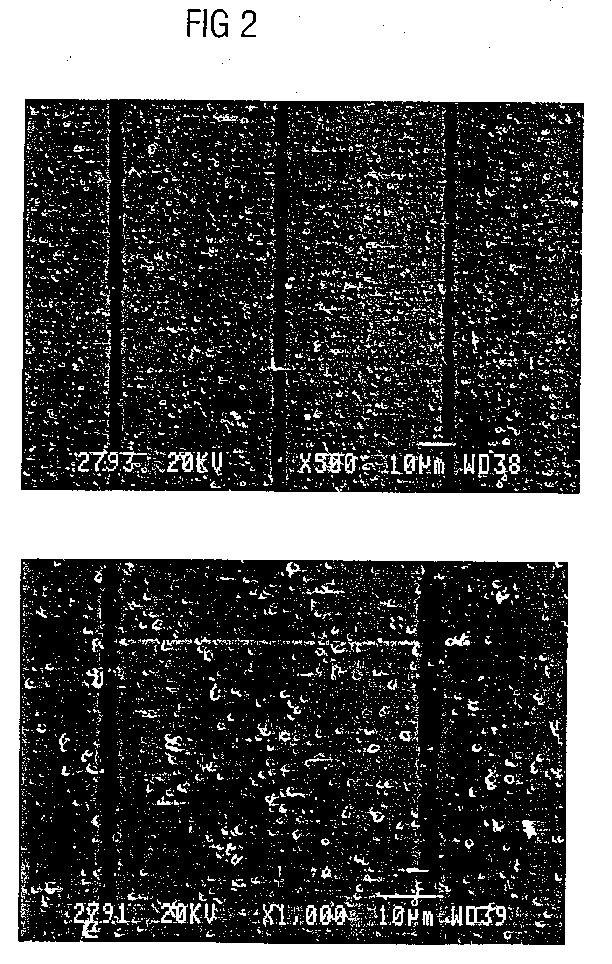

Figur 2 zeigt ausschnittweise einen schematischen Querschnitt durch einen Vielschichtstapel mit alternierender Abfolge von PZT - Keramikfolien und Cu - Innenelektroden in 500-facher (oben) und in 1000-facher (unten) Vergrößerung.

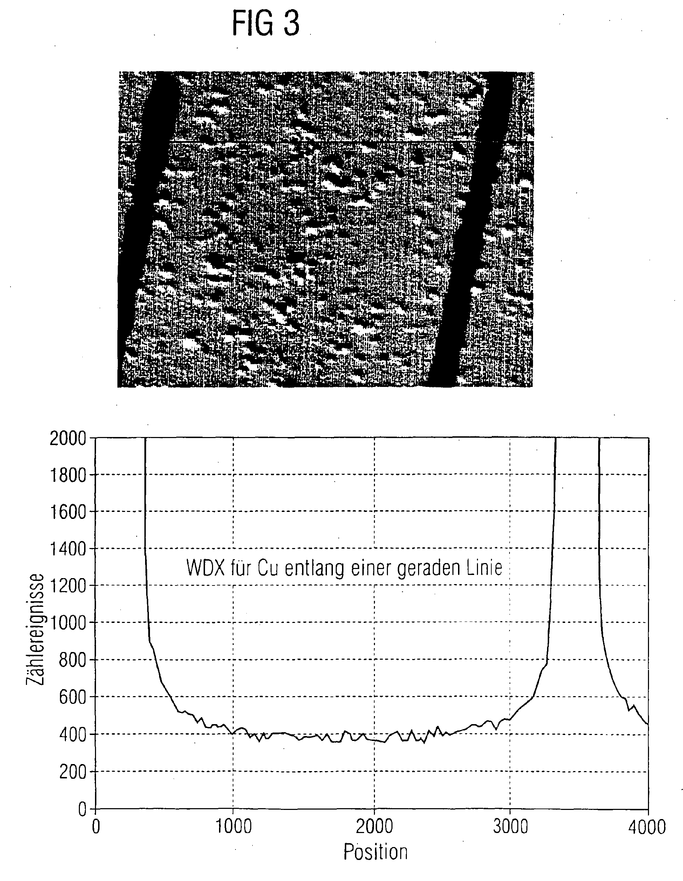

Figur 3 zeigt eine Meßkurve für den Cu - Gehalt der ebenfalls abgebildeten Piezokeramikschicht über die Schichtdicke nach der Sinterung eines Piezostacks auf der Basis der eingesetzten Ausgangszusammensetzung $Pb^{II}_{0,97-y}Nd_{0,02}Cu_yV''_{0,01}(Zr_{0,54-z}Ti_{0,46+z})O_3$. Man erkennt, daß der Kupfergehalt in der Keramikschicht, ausgehend vom Rand abfällt. Die Kalibrierung ergibt in der Mitte der Keramikschicht den minimalen Betrag von y = 0.001. An den Rändern ergibt sich ein 20-fach höherer Wert. Etwas Bleioxid wird unter der Einwirkung der eindiffundierenden Cu - Ionen aus der Verbindung verdrängt. Die gute Anbindung der Cu - Innenelektrode an die Keramik wird dadurch belegt.

Die elektrischen Eigenschaften von Vielschicht - Keramikbauteilen VS der Ausgangszusammensetzung $Pb_{0,97}Nd_{0,02}V_{0,0}1(Zr_{0,54}Ti_{0,46})O_3$ nach der Sinterung bei 1000°C mit 16 Cu - Innenelektroden und zum Vergleich mit 20 Ag/Pd - Innenelektroden (70/30) nach der Sinterung bei 1120°C an der Luft sind in Tabelle 6 angegeben.

Tabelle 6: Elektrische Eigenschaften von PZT Vielschicht - Keramikproben VS auf der Basis der Ausgangszusammensetzung $Pb^{II}_{0,97}Nd^{III}_{0,02}V''_{0,01}(Zr_{0,54}Ti_{0,46})O_3$: (a) Pulver vorgemahlen, mittlere Korngröße $d_{50\%}= 0,53\,\mu m$, 20 Innenelektroden Ag/Pd (70/30), Sinterung bei 1120°C an der Luft, (c) Pulver feingemahlen, mittlere Korngröße $d_{50\%}= 0,33\,\mu m$, 16 Cu - Innenelektroden, Sinterung bei 1000°C unter Inertbedingungen unter $N_2/H_2O$-Dampf.

| Probe VS | Anmerkungen | C/nF | ε vor Polung | ε nach Polung | tan δ nach Polung | $\rho_{IS}/\Omega cm$ nach Polung |
|---|---|---|---|---|---|---|
| (a) | Ag/Pd(70/30): Entbinderung/ Sinterung 1120°C an Luft, Cu-terminiert. | 125±5 | 1104±5 4 | 1561±9 2 | 0,015 | 7,9 $10^{11}$ |
| (c1) | Cu-Innenelektroden : Entbinderung/ Sinterung unter $N_2/H_2O$-Dampf, Cu-terminiert. | 110±4 | 908±35 | 953±37 | 0,027 | 2,7 $10^{10}$ |
| (c2) | Cu-Innenelektroden : Entbinderung/ Sinterung unter $N_2$, $H_2O$-Dampf, Cu-terminiert. | 114±4 | 946 | 1013 | 0,026 | 1,6 $10^{10}$ |

Herstellung eines Piezoaktors aus einer Keramik vom PZT - Typ mit Cu - Innenelektroden.

Zur Herstellung von Piezoaktoren mit zunächst 160 Cu - Innenelektroden werden die nach dem beschriebenen Verfahren hergestellten Grünfolien der Dicke von 40 bis 50 $\mu m$ nach dem für Vielschicht - Keramikkondensatoren bekannten Standardverfahren weiterverarbeitet. Die Bedruckung der quadratisch zugeschnittenen PZT - Keramikfolien erfolgt maschinell in Siebdrucktechnik (400 mesh) mit dem für Piezoaktoren üblichen Elektroden - Design unter Verwendung einer kommerziellen Cu - Elektrodenpaste. Die Stapelung wird in der Weise vorgenommen, daß jeweils auf zwei unbedruckte Folien eine bedruckte folgt. Nach dem Laminieren erhält man aus dem Block durch Stanzen oder Sägen 100 Piezoaktoren im grünen Zustand.

Die Entbinderung wird entsprechend dem in Figur 1 dargestellten Temperatur - Zeitdiagramm im Stickstoffstrom unter Zudosierung von Wasserdampf und Wasserstoff vorgenommen, so daß sich im Bereich von 500°C ein Vorgabewert von $5_* 10^{-2}$ bis $2_*10^{-1}$ Pa für den $O_2$-Partialdruck ergibt. Lokal treten während der Entbinderung wesentlich geringere Sauerstoffpartialdrücke auf. Die Keramik unterliegt im Temperaturbereich der Entbinderung nicht der reduktiven Degradation, weil der Gleichgewichtssauerstoff-partialdruck thermodynamisch bedingt gleichfalls abgesenkt ist und Reduktionsprozesse kinetisch noch hinreichend gehemmt sind. Die Grünteile der Vielschicht - Piezoaktoren weisen nach der Entbinderung noch einen Restgehalt an Kohlenstoff von 300 ppm auf und lassen sich unmittelbar im Anschluß in der gleichen eingestellten Atmosphäre sintern, ohne daß reduktive Degradation eintritt, die zur Rißbildung, Delamination und schließlich zum Auslaufen der Innenelektroden infolge Bildung einer niedrig schmelzenden Cu/Pb - Legierung führen würde.

Dem Stickstoffstrom werden Wasserdampf und Formiergas ($N_2$ + 5 % $H_2$) zudosiert. Die Dissoziation des Wasserdampfes nach

$$H_2O \Leftrightarrow H_2 + \frac{1}{2}O_2$$

wird zur Einstellung eines bestimmten Sauerstoffpartialdrucks genutzt. Entsprechend dem Massenwirkungsgesetz

$$K_D = \frac{p(O_2)^{\frac{1}{2}} \cdot p(H_2)}{p(H_2O)}$$

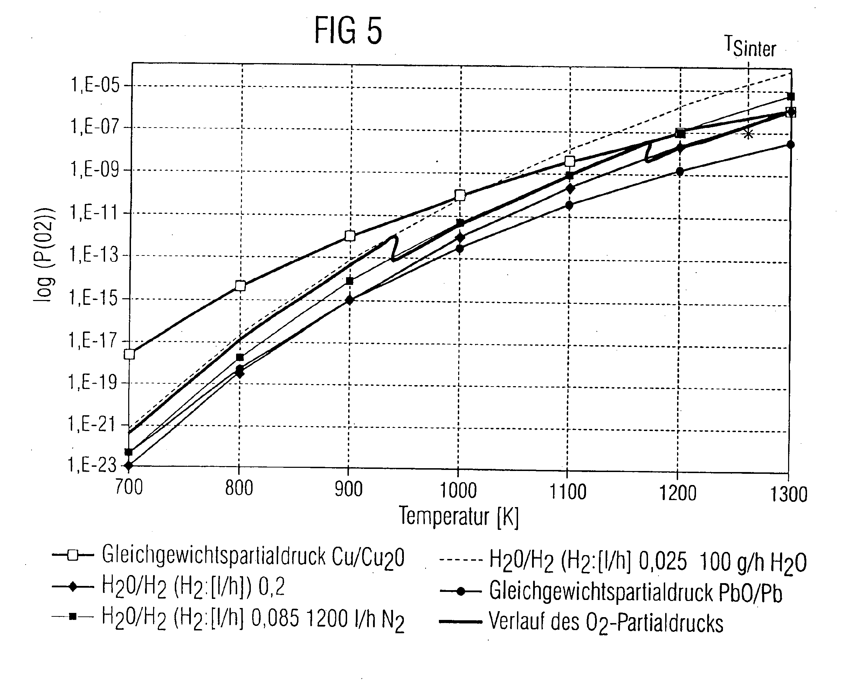

ist damit bei gegebener Temperatur für ein definiertes Partialdruckverhältnis von Wasserdampf und Wasserstoff ein bestimmter Sauerstoffpartialdruck festgelegt. Die Berechnung aus thermodynamischen Daten ergibt die in Fig. 5 gezeigten Kurvenverläufe für verschiedene $H_2/H_2O$-Konzentrationsverhältnisse.

Üblicherweise wird die Gaszusammensetzung so gewählt, dass sich der geforderte Sauerstoffpartialdruck bei der Sintertemperatur $T_{Sinter}$ ergibt. Dieser Zustand ist z. B. in Fig. 5 durch * gekennzeichnet . Von diesem Wert ausgehend verläuft der $p(O_2)$ parallel zu den anderen Kurven mit abnehmender Temperatur. Das bedeutet aber, dass für $T < T_{Sinter}$ der $p(O_2)$ - Wert zu tief liegt, was aus kinetischen Gründen gegebenenfalls tolerierbar ist. Dieser Vorgangsweise entspricht die Gassteuerungskurve Cu1 nach Tab. 7. Dabei wird bedingt durch das schmale thermodynamische Fenster das Gleichgewicht von Pb/PbO schon ab ca. 900 °C unterschritten, wodurch bei ausreichender kinetischer Aktivierung metallisches Blei entsteht.

Alternativ dazu wurde $p(O_2)$ in Stufen mit unterschiedlicher Formiergasdosierung entsprechend Gassteuerung Cu2 eingestellt, der tatsächliche Verlauf des Sauerstoffpartialdrucks liegt damit bis 400 °C im thermodynamischen Fenster. Für die wenig reduktionsstabile PZT-Masse ist diese Vorgangsweise günstig. Die verwendeten Einstellungen Cu1 und Cu2 für die Gassteuerung sind in Tabelle 7 angegeben. Fig. 5 zeigt den berechneten Verlauf des Partialdrucks für die unterschiedlichen Konzentrationsverhältnisse der Gase.

Tab. 7: Gassteuerung Cu1 und Cu2

|  | Cu1 | Dosie rung | Cu2 | Dosierung |
|---|---|---|---|---|
| $N_2$ | gesamte Sinte rung | 900 l/h | gesamte Sinterung | 1200 l/h |
| $H_2/H_2O$ | gesamte Sinte rung | 40 g/h | gesamte Sinterung | 100 g/h |
| $N_2$ + 5% H2 | gesamte Sinte rung | 256 ml/h | 25 - 650 °C | 25 ml/h |
|  |  |  | 650 - 900 °C | 85 ml/h |
|  |  |  | 900 - 1000 °C | 200 ml/h |
|  | Taupunkt 36 °C |  | Taupunkt 48 °C |  |

Das Sinterprofil ist wie folgt: Die Haltezeit bei Maximaltemperatur liegt zwischen 2 und 12 h. Die Aufheizrampe und die Abkühlrampe werden mit 5 K/min durchfahren, bei Aktoren wird langsam mit 1 K/min aufgeheizt. Mit der Temperaturkurve konform läuft die in Stufen angepasste Einstellung des Sauerstoffpartialdrucks (Fig. 5), was durch eine Verstellung des Formiergas-Flowmeters erreicht wird. Dabei ist der Wasserdampfpartialdruck (100 g/h) konstant.

Die erhaltene Keramik ist auf > 96% dicht gesintert und zeigt weitgehend homogene niedrige Porosität. Die Sinterkörner wachsen auf eine für die piezoelektrischen Eigenschaften günstige mittlere Korngröße von 0.8 - 5 $\mu$m.

Man erhält intakte rißfreie Aktoren. Deren Abfolge der Innenelektroden und PZT - Keramikschichten ist in einem Ausschnitt in Figur 2 dargestellt. Die mittlere Korngröße im Keramikgefüge beträgt $d_{50}$ =1,6 $\pm$ 0,3 $\mu$m. Sie liegt damit in einem für die Ausbildung piezoelektrisch aktiver Domänen günstigen Bereich.

Zur Terminierung werden die Piezoaktoren geschliffen und poliert und im Bereich der austretenden Innenelektroden mit einer für derartige Anwendungen handelsüblichen Cu - Paste kontaktiert und nach einer vorgegebenen Temperatur - Zeitkurve bei 935°C eingebrannt. Nach dem Anbringen von Drähten mittels üblicher Bond - Technologie sind die Piezoaktoren der elektrischen Messung zugänglich.

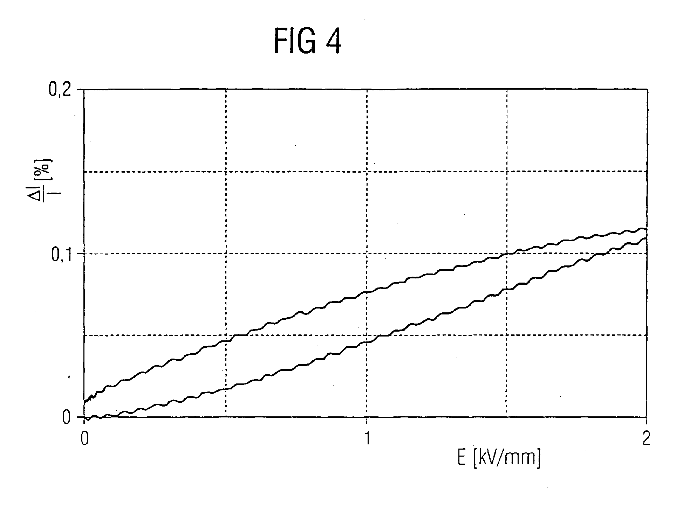

Das Diagramm einer Auslenkungskurve für einen gepolten PZT - Piezoaktor mit 160 Cu - Innenelektroden ist in Figur 4 wiedergegeben. Bei einer Dicke der PZT - Keramikschichten von 70 $\mu$m ergibt sich beim Anlegen einer Spannung von 140,6 Volt entsprechend einer Feldstärke von 2008 V/mm eine Dehnung von 0,123 %. Der piezoelektrische Koeffizient in Richtung des angelegten Feldes $d_{33}$ beträgt 614,6 $10^{-12}$ m/V.

**Patentansprüche**

1. Zwischenprodukt für die Herstellung eines piezoelektrischen Bauelements in monolithischer Vielschichtbauweise, wobei das Zwischenprodukt einen laminierten Stapel von mindestens zwei keramischen Grünfolien und Elektrodenschichten enthält, wobei zwischen zwei keramischen Grünfolien eine kupferhaltige Elektrodenschicht angeordnet ist, wobei die keramischen Grünfolien Polyurethan als thermohydrolytisch abbaubaren Binder enthalten.

2. Zwischenprodukt nach Anspruch 1,
bei dem die Dichte der Keramikschichten mindestens 96 % der theoretisch erreichbaren Dichte aufweist.

3. Zwischenprodukt nach einem der Ansprüche 1 bis 2,
bei dem die Keramikschichten Körner mit einer Korngröße zwischen 0,8 und 5 $\mu$m enthalten.

4. Zwischenprodukt nach einem der Ansprüche 1 bis 3,
bei dem die Keramikschichten eine ferroelektrische Perowskitkeramik mit der allgemeinen Zusammensetzung $ABO_3$ umfassen.

5. Zwischenprodukt nach Anspruch 4,
bei dem die Perowskit-Keramik vom PZT-Typ $Pb(Zr_xTi_{1-X})O_3$ ist.

6. Zwischenprodukt nach einem der Ansprüche 4 oder 5,
bei dem auf A-Plätzen der Keramik Kationen eingebaut sind und bei dem Kationen auf B-Plätzen durch geeignete andere Kationen oder Kombinationen von Kationen ersetzt sind.

7. Zwischenprodukt nach 6,
bei dem auf A-Plätzen der Keramik zweiwertige Metallkationen $M^{II}$ eingebaut sind.

8. Zwischenprodukt nach Anspruch 7,
bei dem die zweiwertigen Metallkationen $M^{II}$ aus einer Gruppe von Elementen ausgewählt sind, die Barium, Strontium, Kalzium und Kupfer enthält.

9. Zwischenprodukt nach einem der Ansprüche 4 bis 8,
bei dem auf A-Plätzen der Keramik partiell dreiwertige Metallkationen $M^{III}$ eingebaut sind, die aus einer Gruppe von Elementen enthaltend Scandium, Yttrium, Wismut und Lanthan oder aus der Gruppe der Lanthaniden ausgewählt sind.

10. Zwischenprodukt nach einem der Ansprüche 4 bis 9,
bei dem auf A-Plätzen der Keramik einwertige Kationen eingebaut sind.

11. Zwischenprodukt nach Anspruch 10,
bei dem die einwertigen Kationen ausgewählt sind aus einer Gruppe von Elementen, die Silber, Kupfer, Natrium und Kalium enthält.

12. Zwischenprodukt nach einem der Ansprüche 8 bis 11,
bei dem Kombinationen von zweiwertigen Metallkationen $M^{II}$ und einwertigen Kationen auf A-Plätzen der Keramik eingebaut sind.

13. Zwischenprodukt nach Anspruch 5,
bei dem zur partiellen Substituion der vierwertigen Kationen Zr und Ti auf den B - Plätzen der ferroelektrischen Perowskit - Keramik Kombinationen ein- und fünfwertiger Metallkationen $M^I_{1/4}M^V_{3/4}$ mit $M^I$ = Na, K und $M^V$ = Nb, Ta oder zwei- und fünfwertiger Metallkationen $M^{II}_{1/3}M^V_{2/3}$ mit $M^{II}$ = Mg, Zn, Ni, Co und $M^V$ = Nb, Ta oder drei- und fünfwertiger Metallkationen $M^{III}_{1/2}M^V_{2/3}$ mit $M^{III}$ = Fe, In, Sc, schwerere Lanthaniden - Elemente und $M^V$ = Nb, Ta oder Kombinationen $M^{III}_{2/3}M^{VI}_{1/3}$ mit $M^{III}$ = Fe, In, Sc, schwerere Lanthaniden - Elemente und $M^{VI}$ = W oder $M^{II}_{1/2}M^{Vi}_{1/2}$ mit $M^{II}$ = Mg, Co, Ni und $M^{VI}$ = W eingesetzt sind.

14. Zwischenprodukt nach Anspruch 5,
bei dem die Zusammensetzung der allgemeinen Formel $Pb_{1-x-y}SE_xCu_yV'''_{x/2}(Zr_{0,54-z}Ti_{0,46+z})O_3$ entspricht mit 0,01 < x < 0,05 und -0,15 < z < +0,15 sowie 0 < y < 0,06, wobei SE ein Seltenerdmetall und V eine Vakanz ist, und wobei ein PbO - Überschuß von 1 bis maximal 5 mol-% eingestellt ist.

15. Zwischenprodukt nach einem der Ansprüche 1 bis 14,
bei dem die Keramik einen Zusatz an CuO enthält.

**Claims**

1. Intermediate product for the production of a piezoelectric component of monolithic multilayer design, wherein the intermediate product contains a laminated stack of at least two ceramic green films and electrode layers, wherein a copper-containing electrode layer is arranged between two ceramic green films, and wherein the ceramic green films contain polyurethane as thermohydrolytically degradable binder.

2. Intermediate product according to Claim 1,
wherein the density of the ceramic layers is at least 96% of the density achievable in theory.

3. Intermediate product according to either of Claims 1 and 2,
wherein the ceramic layers contain grains having a grain size of between 0.8 and 5 $\mu$m.

4. Intermediate product according to one of Claims 1 to 3,
wherein the ceramic layers comprise a ferroelectric perovskite ceramic having the general composition $ABO_3$.

5. Intermediate product according to Claim 4,
wherein the perovskite ceramic is of the PZT type $Pb(Zr_xTi_{1-x})O_3$.

6. Intermediate product according to either of Claims 4 and 5,
wherein cations are incorporated at A sites of the ceramic, and wherein cations at B sites are replaced by other, suitable cations or combinations of cations.

7. Intermediate product according to Claim 6,
wherein divalent metal cations $M^{II}$ are incorporated at A sites of the ceramic.

8. Intermediate product according to Claim 7,
wherein the divalent metal cations $M^{II}$ are selected from a group of elements which comprises barium, strontium, calcium and copper.

9. Intermediate product according to one of Claims 4 to 8,
wherein trivalent metal cations $M^{III}$, which are selected from a group of elements which comprises scandium, yttrium, bismuth and lanthanum or from the group of the lanthanides, are partially incorporated at A sites of the ceramic.

10. Intermediate product according to one of Claims 4 to 9,
wherein monovalent cations are incorporated at A sites of the ceramic.

11. Intermediate product according to Claim 10,
wherein the monovalent cations are selected from a group of elements which comprises silver, copper, sodium and potassium.

12. Intermediate product according to one of Claims 8 to 11,
wherein combinations of divalent metal cations $M^{II}$ and monovalent cations are incorporated at A sites of the ceramic.

13. Intermediate product according to Claim 5,
wherein combinations of monovalent and pentavalent metal cations $M^I_{1/4}M^V_{3/4}$, where $M^I$ = Na, K and $M^V$ = Nb, Ta, or of divalent and pentavalent metal cations $M^{II}_{1/3}M^V_{2/3}$, where $M^{II}$ = Mg, Zn, Ni, Co and $M^V$ = Nb, Ta, or of trivalent and pentavalent metal cations $M^{III}_{1/2}M^V_{2/3}$, where $M^{III}$ = Fe, In, Sc, relatively heavy lanthanide elements and $M^V$ = Nb, Ta, or combinations of $M^{III}_{2/3}M^{VI}_{1/3}$, where $M^{III}$ = Fe, In, Sc, relatively heavy lanthanide elements and $M^{VI}$ = W, or of $M^{II}_{1/2}M^{VI}_{1/2}$, where $M^{II}$ = Mg, Co, Ni and $M^{VI}$ = W, are used for the partial substitution of the tetravalent cations Zr and Ti at the B sites of the ferroelectric perovskite ceramic.

14. Intermediate product according to Claim 5,
wherein the composition corresponds to the general formula $Pb_{1-x-y}SE_xCu_yV'''_{x/2}(Zr_{0.54-z}Ti_{0.46+z})O_3$, where $0.01 < x < 0.05$ and $-0.15 < z < +0.15$ and also $0 < y < 0.06$, SE being a rare earth metal and V being a vacancy, and a PbO excess of 1 to at most 5 mol% being set.

15. Intermediate product according to one of Claims 1 to 14,

wherein the ceramic contains an addition of CuO.

**Revendications**

1. Produit intermédiaire pour la fabrication d'un composant piézoélectrique en mode de construction monolithique à plusieurs couches, dans lequel le produit intermédiaire comporte une pile stratifiée d'au moins deux feuilles à vert en céramique et des couches d'électrode, une couche d'électrode contenant du cuivre étant interposée entre deux feuilles à vert en céramique, les feuilles à vert en céramique contenant du polyuréthanne comme liant décomposable thermohydrolytiquement.

2. Produit intermédiaire suivant la revendication 1, dans lequel la masse volumique des couches en céramique représente au moins 96 % de la masse volumique qui peut être atteinte théoriquement.

3. Produit intermédiaire suivant l'une des revendications 1 à 2, dans lequel les couches en céramique contiennent des grains d'une granométrie comprise entre 0,8 et 5 $\mu$m.

4. Produit intermédiaire suivant l'une des revendications 1 à 3, dans lequel les couches en céramique comprennent une céramique ferroélectrique de perovskite ayant la composition générale $ABO_3$.

5. Produit intermédiaire suivant la revendication 4, dans lequel la céramique de perovskite type PZT est $Pb(Zr_xTi_1-X)O_3$.

6. Produit intermédiaire suivant l'une des revendications 4 ou 5, dans lequel des cations sont incorporés aux sites A de la céramique et dans lequel des cations aux sites B sont remplacés par d'autres cations ou par des combinaisons de cations appropriés.

7. Produit intermédiaire suivant la revendication 6, dans lequel des cations $M^{II}$ de métal bivalents sont incorporés à des sites A de la céramique.

8. Produit intermédiaire suivant la revendication 7, dans lequel les cations $M^{II}$ de métal bivalents sont choisis dans un groupe d'éléments, qui comporte le baryum, le strontium, le calcium et le cuivre.

9. Produit intermédiaire suivant l'une des revendications 4 à 8, dans lequel les cations $M^{III}$ de métal bivalents sont incorporés partiellement à des sites A de la céramique, cations qui sont choisis dans un groupe d'éléments comportant le scandium, l'yttrium, le bismuth et le lanthane ou dans le groupe des lanthanides.

10. Produit intermédiaire suivant l'une des revendications 4 à 9, dans lequel des cations monovalents sont incorporés à des sites A de la céramique.

11. Produit intermédiaire suivant la revendication 10, dans lequel les cations monovalents sont choisis dans un groupe d'éléments qui comporte l'argent, le cuivre, le sodium et le potassium.

12. Produit intermédiaire suivant l'une des revendications 8 à 11, dans lequel des combinaisons de cations $M^{II}$ en métal bivalents et des cations monovalents sont incorporées à des sites A de la céramique.

13. Produit intermédiaire suivant la revendication 5, dans lequel, pour remplacer partiellement les cations Zr et Ti tétravalents aux sites B de la céramique ferroélectrique de perovskite, on utilise les combinaisons de cations $M^I_{1/4}M^V_{3/4}$ de métal monovalent et pentavalent avec $M^I$ = Na, K et $M^V$ = Nb, Ta ou des cations $M^{II}_{1/3}M^V_{2/3}$ de métal bivalent et pentavalent avec $M^{II}$ = Mg, Zn, Ni, Co et $M^V$ = Nb, Ta ou des cations $M^{III}_{1/2}M^V_{2/3}$ trivalents et pentavalents avec $M^{III}$ = Fe, In, Sc, des éléments de lanthanide plus lourds et $M^V$ = Nb, Ta ou des combinaisons $M^{III}_{2/3}M^{VI}_{1/3}$ avec $M^{III}$ = Fe, In, Sc, des éléments de lanthanide plus lourds et $M^{VI}$ = W ou $M^{II}1/2M^{Vi}1/2$ avec $M^{II}$ = Mg, Co, Ni et $M^{VI}$ = W.

**14.** Produit intermédiaire suivant la revendication 5,
dans lequel la composition correspond à la formule générale $Pb_{1-x-y}SE_xCu_yV'''_{x/2}(Zr_{0,54-z}Ti_{0,46+z})O_3$ avec 0,01 < x < 0,05 et -0,15 < z < +0,15 ainsi que 0 < y < 0,06, dans laquelle SE est un métal de terre rare et V est une lacune et dans laquelle on établit un excès de PbO de 1 à au maximum 5 % en mol.

**15.** Produit intermédiaire suivant l'une des revendications 1 à 14,
dans lequel la céramique contient une addition de CuO.

# FIG 1

# FIG 2

# FIG 3

WDX für Cu entlang einer geraden Linie

Zählereignisse

Position

# FIG 4

# FIG 5

$T_{Sinter}$

log (P(O2))

Temperatur [K]

—□— Gleichgewichtspartialdruck Cu/Cu$_2$O      ----- H$_2$O/H$_2$ (H$_2$:[l/h] 0,025  100 g/h H$_2$O

—♦— H$_2$O/H$_2$ (H$_2$:[l/h]) 0,2                      —●— Gleichgewichtspartialdruck PbO/Pb

—■— H$_2$O/H$_2$ (H$_2$:[l/h] 0,085 1200 l/h N$_2$      —— Verlauf des O$_2$-Partialdrucks

EP 1 240 675 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5648012 A
- DE 9700463
- US 5233260 A
- DE 19749858 C1
- DE 19841487

**In der Beschreibung aufgeführte Nicht-Patentliteratur**

- **G. H. Haertling.** *Zeitschriften American Ceramic Society Bulletin,* 1964, vol. 43 (12), 113-118
- *Journal of the American Ceramic Society,* 1971, vol. 54, 1-11
- Piezoelectric Ceramics. Academic Press, 1971
- **B. Jaffe ; W. R. Cook ; H. Jaffe ; von Y. Xu.** Ferroelectric Materials and their Applications. Elsevier Science Publishers, 1991
- **M. Hammer ; M. Hoffmann.** *Journal of Electroceramics,* 1998, vol. 2 (2), 75-84
- **T. Takenaka ; H. Nagata.** *Proceedings of the 11th Internat. Symp. Appl. of Ferroelectrics,* 1998, 59-562
- **Cao ; Mitarbeiter.** *Journal of the American Ceramic Society,* 1993, vol. 76 (12), 3019
- **Kato ; Mitarbeiter.** *Ceramic Transactions,* 1990, vol. 8, 54-68